Europäisches Patentamt

European Patent Office

Office européen des brevets

(19)

(11) Veröffentlichungsnummer : **0 071 917**
**B1**

(12) **EUROPÄISCHE PATENTSCHRIFT**

(45) Veröffentlichungstag der Patentschrift :
21.11.85

(51) Int. Cl.⁴ : **H 03 H 3/08, H 03 H 9/10**

(21) Anmeldenummer : **82106924.2**

(22) Anmeldetag : **30.07.82**

(54) **Elektrisches Bauelement, Bauelementegruppe oder integrierte Schaltung, deren aktiver Teil auf einem Metallträger aufgebracht ist und Verfahren zu ihrer Herstellung.**

(30) Priorität : 12.08.81 DE 3131887

(43) Veröffentlichungstag der Anmeldung :
16.02.83 Patentblatt 83/07

(45) Bekanntmachung des Hinweises auf die Patenterteilung : 21.11.85 Patentblatt 85/47

(84) Benannte Vertragsstaaten :
DE FR GB IT

(56) Entgegenhaltungen :
EP-A- 0 023 109
EP-A- 0 061 648
DE-A- 2 610 172
PATENTS ABSTRACTS OF JAPAN, Band 5, Nr. 121(E-
68)(793), 5. August 1981,

(73) Patentinhaber : Siemens Aktiengesellschaft
Berlin und München Wittelsbacherplatz 2
D-8000 München 2 (DE)

(72) Erfinder : Pilz, Dieter, Dipl.-Ing.
Zugspitzstrasse 6
D-8039 Puchheim (DE)
Erfinder : Steizl, Hans, Ing.grad.
Rotkehichenweg 4
D-8011 Vaterstetten (DE)
Erfinder : Wagmann, Walter
Haidgraben 93
D-8012 Ottobrunn (DE)

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

Die Erfindung betrifft ein elektrisches Bauelement, eine Bauelementegruppe oder eine integrierte Schaltung, deren aktiver Teil auf einem Metallträger aufgebracht ist, insb. ein Oberflächenwellenfilter mit wenigstens einem Eingangs- und Ausgangswandler auf der einen Seite eines insb. einkristallinen piezoelektrischen Körpers, als aktiver Teil, der mit seiner anderen Seite auf dem elektrisch an Masse anzuschließenden Metallträger befestigt ist, an dessen einer Lägsseite und in etwa gleicher Ebene verlaufend wenigstens eine Anschlußfahne für diesen Masseanschluß und weitere, elektrisch und mechanisch getrennte Anschlußfahnen für die Stromzuleitung zu bzw. Stromableitung von dem aktiven Teil über Verbindungsdrähte vorhanden sind, wobei der aktive Teil, insb. der piezoelektrische Körper, der Metallträger und die Verbindungsdrähte in einem Gehäuse untergebracht sind, dessen Öffnung mit einem Kunststoffteil und mit Kleb- und/oder Vergußmaterial verschlossen ist und die Anschlußfahnen durch den Kunststoffteil hindurch nach außen ragen. Ein Oberflächenwellenfilter dieser Art ist durch die EP-A-0 023 109 bekannt.

Elektrische Bauelemente, auf die sich die vorliegende Erfindung bezieht, sind passive und aktive Bauelemente, (Widerstände, Kondensatoren, Induktivitäten, Relais, Dioden, Transistoren), Bauelementegruppen (auf eine Platine aufgetragene, miteinander verschaltete passive und/oder aktive elektrische Bauelemente), integrierte Schaltungen und insb. elektrische Oberflächenwellenfilter.

Passive und aktive elektrische Bauelemente sind hinreichend bekannt. Ebenso Bauelementegruppen der oben erläuterten Art und integrierte Schaltungen.

Integrierte Schaltungen, z. B. Operationsverstärker, sind beispielsweise in dem Buch der Fa. Siemens : « Bauelemente, technische Erläuterungen und Kenndaten für Studierende », 2. Auflage, 1977, auf Seite 186 beschrieben.

Elektrische Oberflächenwellenfilter der geschilderten Art sind beispielsweise in der US-A-3 836 876, in der DE-B-2 845 610 und in der Zeitschrift « Siemens Components », 18. Jahrgang, Heft 4, August 1980, Seiten 167 bis 169 dargestellt und beschrieben.

Bei den hier in Rede stehenden elektrischen Oberflächenwellenfiltern handelt es sich um solche, die senkrecht stehend auf eine gedruckte Schaltungsplatte einbaubar sind, indem die Anschlußfahnen in der Ebene des Metallträgerkörpers aus dem Gehäuse herausragen, wie dies in der genannten Zeitschrift « Siemens Components » erläutert ist.

Eine andere Art der Einbauweise elektrischer Oberflächenwellenfilter in gedruckte Schaltungen sieht vor, daß die Anschlußfahnen des Metallträgerkörpers um einen Winkel von 90° in einer Richtung hin abgebogen sind, so daß das Oberflächenwellenfilter parallel zur Oberfläche der gedruckten Schaltungsplatte nach dem Einbau angeordnet ist. Ein solches Oberflächenwellenfilter ist in der Zeitschrift « Siemens Components », 18. Jahrgang, 1980, Heft 1, Seiten 44 und 45 geziegt und ein Gehäuse hierfür ist in der DE-A-3 011 730.7, veröffentlicht am 01.10.1981, beschrieben.

Andere Ausführungsformen von Oberflächenwellenfilter für waagerechten Einbau sind in der DE-A-2 609 884 (prioritätsgleich mit US-A-4 047 129) und in der DE-B-2 610 172 (prioritätsgleich mit US-A-4 034 318) beschrieben.

Es ist andererseits hinreichend bekannt, elektrische Bauelemente, auf die sich die vorliegende Erfindung bezieht, — mit Ausnahme von Oberflächenwellenfiltern — zum Zwecke der Abschirmung in Metallgehäuse einzubauen. In aller Regel bestehen solche Metallgehäuse aus einem Becher runden oder rechteckigen Querschnitts und einem Metalldeckel, durch den hindurch Anschlußstifte — isoliert mittels Glasperlen oder anderen isolierenden Materialien — hindurchgeführt sind. Der Anschluß an Masse solcher Gehäuse geschieht über einen Anschlußstift, der mit dem Deckel und/oder dem Becher des Metallgehäuses galvanisch verbunden ist.

Die Herstellung solcher Abschirmmetallgehäuse ist sowohl im Hinblick auf das Material als auch im Hinblick auf die aufzuwendende Arbeitsleistung sehr kostenaufwendig und deshalb für elektrische Bauelemente, die in sehr hohen Stückzahlen (einige Millionen pro Jahr) kostengünstig hergestellt werden müssen, nicht anwendbar.

Elektrische Bauelemente, Bauelementegruppen und integrierte Schaltungen, auf die sich die vorliegende Erfindung bezieht, wie insb. Oberflächenwellenfilter werden kostengünstig auf praktisch ebenen metallischen Trägerelementen, sog. Spinnen, aufgebaut, wobei das eigentliche Bauteil, nämlich der aktive Teil des elektrischen Bauelementes, der beispielsweise ein Chip sein kann, auf einem ebenen oder speziell geformten Metallträger, der z. B. eine wannenförmige Vertiefung aufweist, befestigt wird. Die Anschlüsse des aktiven Bauteiles werden mit an einer Seite des Metallträgers angeordneten Anschlußfahnen der Spinne mittels zusätzlicher Drähte verbunden. Die Anschlußteile werden mittels eines Kunststoffteiles zusammengehalten. Eine oder mehrere der Anschlußfahnen können zur elektrischen Abschirmung und zur mechanischen Stabilisierung mit dem Trägerblech galvanisch verbunden sein. Das vollständig montierte elektrische Bauelement wird zum Schutz gegen mechanische und klimatische Einflüsse mit einem Kunststoffbecher aus elektrisch nicht leitendem Material abgedeckt und mit dem genannten Kunststoffteil z. B. mittels Vergußmasse verbunden. Aus Gründen der besseren elektromagnetischen Abschirmung ist es jedoch üblich, anstelle des Kunststoffbechers ein Metallgehäuse zu verwenden, das mit dem Metallträger des aktiven Teiles galvanisch verbunden sein muß.

Der vorliegenden Erfindung liegt die Aufgabe zugrunde, bei gleich guter elektromagnetischer Abschirmung das Metallgehäuse durch ein leicht herstellbares Kunststoffgehäuse zu ersetzen.

Zur Lösung dieser Aufgabe sieht die Erfindung vor, daß das Gehäuse ein Kunststoffgehäuse aus elektrisch leitfähigem Material ist und mit seiner Öffnung den Kunststoffteil überragt, und daß der Metallträger an wenigstens einem Ende seiner zum Kunststoffteil gerichteten Längsseite in eine zusätzliche Masseanschlußfahne übergeht, die in ihrem vom Kunststoffteil nach außen gekehrten Bereich mit dem überragenden Teil des Kunststoffgehäuses mittels leitfähigem Kleber galvanisch verbunden ist.

Da die galvanische Verbindung zwischen Metallträger und Kunststoffgehäuse direkt am Bauelement erfolgt und nicht erst auf der eine gedruckte Schaltung tragenden Platine, ist die Stromschleife kleiner und damit die Abschirmwirkung besser ; und es sind die elektrischen Meßwerte des Bauelementes weitgehend von der Meßfassung bzw. von der Platine unabhängig. Weil das Metallgehäuse nicht mit einem lötfähigen Anschlußbein versehen ist, sind die Material- und Verarbeitungskosten geringer. Zusätzlich muß der Anwender des elektrischen Bauelementes keine besonderen Vorkehrungen in der gedruckten Schaltung treffen.

Für eine gute Verbindung zwischen den Masseanschlußfahnen und dem Kunststoffgehäuse ist es vorteilhaft, daß die an den Masseanschlußfahnen bei ihrer Herstellung erzeugten Trennstellen stumpf an der Innenwand des Kunststoffgehäuses anliegen oder höchstens einen Abstand von 0,2 mm von der Innenwand haben.

Zur Erzeugung einer Verbindungsstelle zwischen Anschlußfahne und Kunststoffgehäuse, die ohne Überstehen der Anschlußfahne herstellbar ist, ist es vorteilhaft, wenn die Masseanschlußfahnen mit ihrem freien Ende in einen am Kunststoffgehäuserand ausgebildeten Schlitz eintaucht und mittels leitfähigem Kleber mit dem Kunststoffgehäuse galvanisch verbunden ist.

Die Erfindung betrifft ferner ein Verfahren zur Herstellung eines elektrischen Bauelementes, einer Bauelementegruppe oder integrierten Schaltung der eingangs genannten. Art, bei dem die Metallträger samt Anschlußfahnen zunächst aus einem zusammenhängenden Metallband derart ausgestanzt werden, daß der Zusammenhalt mehrerer Metallträger durch einen Grundstreifen, mit dem die Anschlußfahnen verbunden bleiben, und durch Verbindungsstücke, die zusammen mit der Anschlußfahne für den Masseanschluß die Verbindung zwischen Metallträger und den Anschlußfahnen ergeben, gewährleistet ist, wonach der Kunststoffteil um die inneren Anschlußteile der Anschlußfahnen und um Metallstreifen am Metallträger zu den Verbindungsstücken geformt wird, vorher oder danach der aktive Teil am Metallträger befestigt und entsprechend mittels Drähten mit den inneren Anschlußteilen elektrisch verbunden wird, dann die Verbindungsstücke entfernt werden, das Kunststoffgehäuse auf den Kunststoffteil aufgesetzt und mit ihm durch Kleb- und/oder Vergußmaterial verbunden und dicht verschlossen wird, und schließlich die Anschlußfahnen in entsprechender Länge vom Grundstreifen abgetrennt werden, wobei der Übergang von den Metallstreifen des Metallträgers zu den Verbindungsstücken beim Ausstanzen und beim Entfernen der Verbindungsstücke so geformt wird, daß Masseanschlußfahnen entstehen, die zur Innenwand des Kunststoffgehäuses gerichtet sind und an ihr nach Aufsetzen des Kunststoffgehäuses stumpf anliegen oder in Schlitze im Gehäuserand eintauchen oder höchstens in einem Abstand von 1 mm von ihr stehen, wonach die elektrische Verbindung zwischen Kunststoffgehäuse und Masseanschlußfahnen durch Kleben mittels elektrisch leitfähigem Kleber erfolgt.

Ein ähnliches Verfahren ist aus der EP-A-0 061 648, veröffentlicht am 6.10.1982, bekannt.

Die Erfindung wird nachfolgend und unter Bezugnahme auf die Zeichnungen näher erläutert.

Es zeigen :

Figur 1 einen teilweisen Schnitt längs der Linie I-I in Fig. 2 durch ein Bauelement, im vorliegenden Fall ein Oberflächenwellenfilter ;

Figur 2 einen Schnitt gemäß der Linie II-II in Fig. 1 des gleichen Bauelementes ;

Figur 3 ein in Fig. 1 strichliniert angedeutetes Detail III in geänderter Ausführung ;

Figur 4 einen Ausschnitt, der das Herstellungsverfahren verdeutlicht ;

Figur 5 ebenfalls einen Ausschnitt zur Erläuterung des Herstellungsverfahren mit einer anderen Form der ausgestanzten Metallelemente.

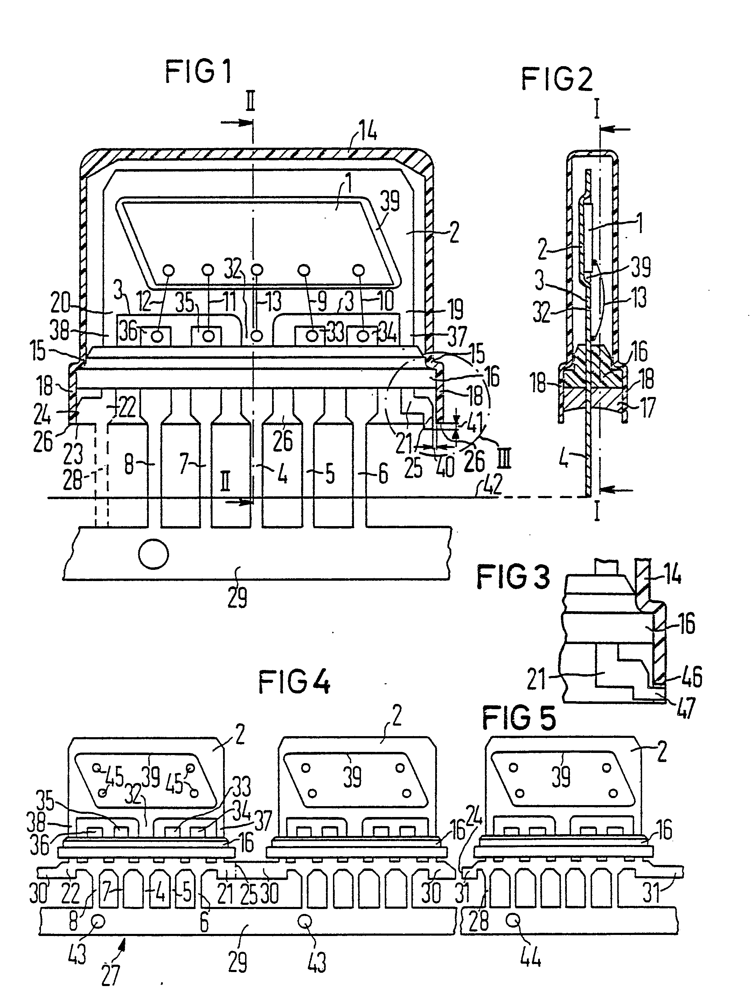

In Figur 1 ist mit 1 der aktive Teil des elektrischen Bauelementes, im vorliegenden Fall eine piezoelektrische einkristalline Platte — üblicherweise aus Lithiumniobat bestehend — gezeigt. Die verschiedenen Wandlerelektroden und Kopplerteile sind aus Gründen der Übersichtlichkeit hier nicht dargestellt.

Der aktive Teil 1 ist auf einem Metallträger 2 befestigt, der zu diesem Zweck vorzugsweise mit einer wannenförmigen Vertiefung versehen ist. Die Rückseite des aktiven Teiles 1 ist beispielsweise durch Klebverbindung mit dem Metallträger 2 verbunden.

An der Längsseite 3 des Metallträgers 2 sind Anschlußfahnen 4 bis 8 vorhanden, die in gleicher Ebene wie der Metallträger 2 verlaufen. Die als Masseanschluß wirksame Anschlußfahne 4 ist mit dem Metallträger 2 aus einem Stücke bestehend hergestellt, d. h. ihr innerer Anschlußteil 32 geht in den Metallträger 2 über.

Der innere Teil 32 der Anschlußfahne 4 und die inneren Teile 33 bis 36 der Anschlußfahnen 5 bis 8 sind durch Drähte 9 bis 13 mit den jeweiligen Anschlußstellen des aktiven Teiles 1 verbunden. Die Drähte können dabei in an sich bekannter Weise durch Thermokompression an den jeweiligen Stellen befestigt werden. Am rechten Ende 19 und gegebenenfalls auch am linken Ende 20 der Längsseite 3 des Metallträgers 2 sind Metallstreifen 37 und 38 vorgesehen, die in Masseanschlußfahnen 21 und 22 übergehen.

Es genügt an sich, wenn nur eine solche Masseanschlußfahne 21 vorhanden ist. Es kann aber auch eine weitere Masseanschlußfahne 22 vorhanden sein, die gegebenenfalls auch in eine weitere Masseanschlußfahne 22 vorhanden sein, die gegebenenfalls auch in eine weitere Masseanschlußfahne 28 übergeht (in Fig. 1 deshalb gestrichelt gezeichnet), so daß ein Masseanschluß nicht bloß über die Anschlußfahne 4, deren inneren Anschlußteil 32 und den Draht 13 gewährleistet ist, sondern daß auch der Metallträger 2 über den Metallstreifen 38, die Masseanschlußfahne 22 und die weitere Masseanschlußfahne 28 an Masse anschließbar ist.

Das aus elektrisch leitfähigem Kunststoff bestehende Kunststoffgehäuse 14 ist über den gesamten aktiven Teil 1, den Metallträger 2, die Zuleitungsdrähte 9 bis 13, die inneren Anschlußteile 32 bis 36 und einen Kunststoffteil 16 gestülpt, wofür das Kunststoffgehäuse 14 dem Kunststoffteil 16 angepaßte Abknickungen 15 aufweist, damit ein guter und dichter Verschluß gewährleistet ist. Die Abknickungen 15 gehen in einen den Kunststoffteil 16 überragenden Teil 18 über, so daß ein Hohlraum entsteht, der entweder mit Klebmaterial oder — wie im vorliegenden Fall (Fig. 2) — mit Vergußmasse 17 ausgefüllt wird, so daß ein hermetischer Verschluß resultiert.

Die Anschlußfahnen 4 bis 8, 21 und 22 sind fest in den Kunststoffteil 16 eingebettet.

Im linken Teil von Fig. 1 ist gezeigt, daß die Masseanschlußfahne 22 mit ihrer Trennstelle 24 stumpf am den Kunststoffteil 16 überragenden Teil 18 des Kunststoffgehäuses 14 anliegt und daß durch eine Klebverbindung 23 mit elektrisch leitfähigem Kleber der galvanische Kontakt zwischen Metallträger 2 und Kunststoffgehäuse 14 gewährleistet ist.

Im rechten Teil von Fig. 1 ist die Anordnung der Masseanschlußfahne 21 gegenüber dem überragenden Teil 18 vor der Herstellung der Klebverbindung gezeigt. Die Trennstelle 25 ist durch entsprechende gegenseitige Bemessung von Gehäuse und Anordnung der Masseanschlußfahne in einem Abstand 40 zwischen der Trennstelle 25 und dem überragenden Teil 18 angeordnet.

Im Ausführungsbeispiel gemäß Fig. 3 ist der Kunststoffgehäuserand 26 mit einem Schlitz 46 ausgebildet, in den das freie Ende 47 der Masseanschlußfahne 21 eintaucht und mittels in der Zeichnung nicht dargestelltem elektrisch leitfähigem Kleber mit dem Kunststoffgehäuse 14 galvanisch verbunden ist.

Es können an beiden Enden des Metallträgers 2 Masseanschlußfahnen 21 und 22 vorhanden und durch Klebung 23 mit dem Kunststoffgehäuse 14 verbunden sein. Es kann aber auch nur an einem Ende eine solche Klebeverbindung 23 hergestellt werden.

Die Anschlußfahnen 4 bis 8 und ggf. 28 werden längs der Trennlinie 42 vom Metallband abgetrennt. Dieser Vorgang hängt mit dem Herstellungsverfahren gemäß der vorliegenden Erfindung zusammen und wird nachfolgend anhand der Fig. 4 und 5 beschrieben.

Ein elektrisches Bauelement gemäß der Erfindung wird vorzugsweise durch ein Verfahren hergestellt, bei dem die Metallträger 2 samt Anschlußfahnen 4 bis 8 und ggf. 28 zunächst aus einem zusammenhängenden Metallband 27 derart ausgestanzt werden, daß der Zusammenhalt mehrerer Metallträger 2 durch einen Grundstreifen 29 bleiben mit dem Grundstreifen 29 verbunden, und durch Verbindungsstücke 30 und 31 wird, zusammen mit den Anschlußfahnen 4, ggf., 28 für den Masseanschluß die Festigkeit des Metallbandes gewährleistet.

Die Anschlußfahnen 4 bis 8 und ggf. 28 (Fig. 5) werden zusammen in einem Stanzvorgang, bei dem auch die inneren Anschlußteile 32 bis 36 gebildet werden, hergestellt. Dadurch, daß der innere Anschlußteil 32 der Anschlußfahne 4 mit dem Metallträger 2 verbunden bleibt und die Metallstreifen 37 und 38, die zu den Masseanschlußfahnen 21 und 22 führen, ebenfalls mit dem Metallträger verbunden sind, sowie ferner durch die Verbindungsstücke 30 bzw. 31 bleibt der gesamte Metallstreifen 27 zusammenhängend und kann in einer automatischen Vorrichtung gleichzeitig als Transportband verwendet werden, wofür die Löcher 43 und 44 der Zentrierung und dem Transporteingriff dienen.

Beim Ausstanzvorgang wird dafür gesorgt, daß die Masseanschlußfahnen 21 und 22 derart entstehen, daß sie später mit ihren Trennstellen (siehe Fig. 1) am Kunststoffgehäuse 14 anliegen oder im angegebenen Höchstabstand davon angeordnet sind.

Der Kunststoffteil 16 wird um die inneren Anschlußteile 32 bis 36 der Anschlußfahnen 4 bis 8 und um die Metallstreifen 37 und 38 am Metallträger 2, die zu den Verbindungsstücken 30 und 31 führen, geformt.

Vorher oder danach wird der aktive Teil 1 am Metallträger 2 befestigt. Damit insb. bei Oberwellenflächenfiltern unerwünschte Schwingungen unterdrückt werden, sind in der wannenförmigen Vertiefung 39 des Metallträgers zwei Abstandsnoppen angeordnet, beispielsweise wie dies in der DE-OS 2 845 610 beschrieben ist.

Die in Fig. 1 gezeigten Drähte 9 bis 13 oder auch andere Übergangsanschlüsse zu den inneren Anschlußteilen der Anschlußfahnen werden dann zum Zwecke der elektrischen Verbindung beispielsweise durch Thermokompression — wie an sich bekannt — angebracht.

Danach werden die Verbindungsstücke 30 bzw. 31 so entfernt, daß Trennstellen 25 entstehen (Fig. 1).

Auf die derart vorbereiteten Anordnungen werden dann die Kunststoffgehäuse 14 während des automatischen Herstellungsprozesses aufgesetzt, und es wird — wie oben beschrieben — die Klebverbindung 23 hergestellt. Die Klebverbindung 23 kann aber auch noch dem Verschluß mittels Kleb- und/oder Vergußmaterial hergestellt werden.

Bereits zu diesem Zeitpunkt oder auch nach dem Abtrennen der Anschlußfahnen 4 bis 8 und ggf. 28 längs der Linie 42 wird der Verschluß mittels Kleb- und/oder Vergußmaterial erzeugt.

Aus Gründen des Einsatzes von elektrischen Bauelementen gemäß der vorliegenden Erfindung in automatischen Bestückungsvorrichtungen für gedruckte Schaltungen kann es vorteilhaft sein, mehrere solche elektrische Bauelemente am Grundstreifen 26 zu belassen und die Abtrennung längs der Linie 42 erst im Rahmen der Bestückung der gedruckten Schaltung vorzunehmen.

## Patentansprüche

1. Elektrisches Bauelement, Bauelementgruppe oder integrierte Schaltung, deren aktiver Teil (1) auf einem Metallträger (2) aufgebracht ist, insbesondere ein Oberflächenwellenfilter mit wenigstens einem Eingang- und Ausgangswandler auf der einen Seite eines insbesondere einkristallinen piezoelektrischen Körpers, als aktiver Teil (1), der mit seiner anderen Seite auf dem elektrisch an Masse anzuschließenden Metallträger (2) befestigt ist, an dessen einer Längsseite (3) und in gleicher Ebene verlaufend wenigstens eine Anschlußfahne (4) für diesen Masseanschluß und weitere, elektrisch und mechanisch getrennte Anschlußfahnen (5 bis 8) für die Stromzuleitung zu bzw. Stromableitung von dem aktiven Teil (1) über Verbindungsdrähte (9 bis 12) vorhanden sind, wobei der aktive Teil (1), insbesondere der piezoelektrische Körper, der Metallträger (2) und die Verbindungsdrähte (9 bis 15) in einem Gehäuse (14) untergebracht sind, dessen Öffnung (15) mit einem Kunststoffteil (16) und mit Kleb- und/oder Vergußmaterial (17) verschlossen ist, und die Anschlußfahnen (4 bis 8) durch den Kunststoffteil (16) hindurch nach außen ragen, dadurch gekennzeichnet, daß das Gehäuse ein Kunststoffgehäuse (14) aus elektrisch leitfähigem Material ist und mit seiner Öffnung (15) den Kunststoffteil (16) überragt, und daß der Metallträger (2) an wenigstens einem Ende (19, 20) seiner zum Kunststoffteil gerichteten Längsseite (3) in eine zusätzliche Masseanschlußfahne (21, 22) übergeht, die in ihrem vom Kunststoffteil nach außen gekehrten Bereich mit dem überragenden Teil (18) des Kunststoffgehäuses mittels leitfähigem Kleber (23) galvanisch verbunden ist.

2. Elektrisches Bauelement nach Anspruch 1, dadurch gekennzeichnet, daß wenigstens eine der Massenanschlußfahnen (21, 22) so bemessen ist, daß ihre bei der Herstellung erzeugte Trennstelle (24, 25) stumpf an der Innenwand des Kunststoffgehäuses (14) anliegt oder höchstens einen Abstand von 1 mm von der Innenwand hat.

3. Elektrisches Bauelement nach Anspruch 1 oder 2, dadurch gekennzeichnet, daß wenigstens eine der Massenanschlußfahnen (21, 22) mit ihren freien Enden (47) in einen am Kunststoffgehäuserand (26) ausgebildeten Schlitz (46) eintaucht und mittels leitfähigem Kleber mit dem Kunststoffgehäuse galvanisch verbunden ist.

4. Elektrisches Bauelement nach einem der Ansprüche 1 bis 3, dadurch gekennzeichnet, daß wenigstens eine Masseanschlußfahne (21, 22) mit einer Verlängerung versehen ist, die als weitere Masseanschlußfahne (28) für den Masseanschluß dient.

5. Verfahren zur Herstellung eines elektrischen Bauelementes, einer Bauelementegruppe oder integrierten Schaltung, nach einem der Ansprüche 1 bis 5, bei dem die Metallträger (2) samt Anschlußfahnen (4 bis 8 und 28) zunächst aus einem zusammenhängenden Metallband (27) derart ausgestanzt werden, daß der Zusammenhalt mehrerer Metallträger (2) durch einen Grundstreifen (29), mit dem die Anschlußfahnen (4 bis 8 und 28) verbunden bleiben, und durch Verbindungsstücke (30, 31), die zusammen mit der Anschlußfahne (4) für den Masseanschluß die Verbindung zwischen Metallträger (2) und den Anschlußfahnen (5 bis 8 und 28) ergeben, gewährleistet ist, wonach der Kunststoffteil (16) um die inneren Anschlußteile (32 bis 36) der Anschlußfahnen (4 bis 8) und um Metallstreifen (37, 38) am Metallträger (2) zu den Verbindungsstücken (30, 31) geformt wird, vorher oder danach der aktive Teil (1) am Metallträger (2) befestigt und entsprechend mittels Drähten (9 bis 13) mit den inneren Anschlußteilen (32 bis 36) elektrisch verbunden wird, dann die Verbindungsstücke (30, 31) entfernt werden, das Kunststoffgehäuse (14) auf den Kunststoffteil (16) aufgesetzt und mit ihm durch Kleb- und/oder Vergußmaterial (17) verbunden und dicht verschlossen wird, und schließlich die Anschlußfahnen (4 bis 8 und 28) in entsprechender Länge vom Grundstreifen (29) abgetrennt werden, wobei der Übergang von den Metallstreifen (37, 38) des Metallträgers (2) zu den Verbindungsstücken (30, 31) beim Ausstanzen und beim Entfernen der Verbindungsstücke (30, 31) so geformt wird, daß Masseanschlußfahnen (21, 22) entstehen, die zur Innenwand des Kunststoffgehäuses (14) gerichtet sind und an ihr nach Aufsetzen des Kunststoffgehäuses (14) stumpf anliegen oder in Schlitze im Gehäuserand (26) eintauchen oder höchstens in einem Abstand von 1 mm von ihr stehen, wonach die elektrische Verbindung (23) zwischen Kunststoffgehäuse (14) und Masseanschlußfahnen (21, 22) durch Kleben mittels elektrisch leitfähigem Kleber erfolgt.

## Claims

1. An electrical component, component group or integrated circuit, the active part (1) of which is placed on a metal carrier (2), in particular a surface wave filter having at least one input- and output transformer on the one side of a piezo-electric body, in particular a monocrystalline piezo-electric body, as the active part (1), which body has its other side fastened to the metal carrier (2) which is to be electrically connected to earth, and on whose one longitudinal side (3) and extending in the same plane, are arranged at least one connecting lug (4) for the earth connection and further, electrically and mechanically separated connecting lugs (5 to 8) for the current supply to and the current discharge from the active part (1) through connection wires (9 to 12), where the active part (1), (in particular the piezoelectric body) the metal carrier (2) and the connection wires (9 to 15) are accommodated in a housing (14), the opening (15) of which is sealed by means of a synthetic resin part (16) and with adhesive and/or sealing material (17), the connecting lugs (4 to 8) projecting outwards through the synthetic resin part (16), characterised in that the housing is a synthetic resin housing (14) made of an electrically conductive material and projects above the synthetic resin part (16) at its opening (15) ; and that at least at one end (19, 20) of its longitudinal side (3) directed towards the synthetic resin part, the metal carrier (2) passes over into an additional earth connecting lug (21, 22), which in its portion which is turned outwardly from the synthetic resin part, is electrically conductively connected to the protruding part (18) of the synthetic resin housing by means of conductive adhesive (23).

2. An electrical component as claimed in Claim 1, characterised in that at least one of the earth connecting lugs (21, 22) is so dimensioned that its separation point (24, 25), which is produced during production, is flush with the inside wall of the synthetic resin housing (14) or has a maximum distance of 1 mm from the inside wall.

3. An electrical component as claimed in Claim 1 or Claim 2, characterised in that at least one of the earth connecting lugs (21, 22) has its free end (47) dipping into a slot (46) which is formed at the edge (26) of the synthetic resin housing and is electrically conductively connected to the synthetic resin housing by means of a conductive adhesive.

4. An electrical component as claimed in one of Claims 1 to 3, characterised in that at least one earth connecting lug (21, 22) is provided with an extension which serves as a further earth connecting lug (28) for earth connection.

5. A process for the production of an electrical component, component group or integrated circuit as claimed in one of Claims 1 to 5, wherein the metal carriers (2) together with the connecting lugs (4 to 8 and 28) are first punched from a continuous metal strip (27) in such manner that the connection together of a plurality of metal carriers (2) is ensured by the base strip (29), to which the connecting lugs (4 to 8 and 28) remain connected, and by connection pieces (30, 31), which, together with the connecting lug (4) for the earth connection, form the connection between the metal carrier (2) and the connecting lugs (5 to 8 and 28), whereupon the synthetic resin part (16) is formed around the inner terminal parts (32 to 36) of the connecting lugs (4 to 8) and around metal strips (37, 38) on the metal carrier (2) to the connection pieces (30, 31), the active part (1) being previously or subsequently secured to the metal carrier (2) and correspondingly electrically connected to the inner terminal parts (32 to 36) by means of wires (9 to 13), the connection pieces (30, 31) are then removed, the synthetic resin housing (14) is placed on the synthetic resin part (16) and connected and sealed thereto by adhesive and/or sealing material (17) and the connecting lugs (4 to 8 and 28) are finally separated from the base strip (29) at corresponding lengths, wherein, during the punching process and the removal of the connection pieces (30, 31), the junction of the metal strips (37, 38) of the metal carrier (2) to the connection pieces (30, 31) is so formed that earth connecting lugs (21, 22) are produced which are directed towards the inner wall of the synthetic resin housing (14) and, when the synthetic resin housing (14) has been set up, are butt-jointed to said inner wall or dip into slots on the edge (26) of the housing, or are at a maximum distance of 1 mm therefrom, whereupon the electrical connection (23) between the synthetic resin housing (14) and the earth connecting lugs (21, 22) is effected by adhesion using an electrically conductive adhesive.

**Revendications**

1. Composant électrique, groupe de composants électriques ou circuit intégré, dont la partie active (1) est montée sur un support métallique (2), en particulier un filtre à ondes de surface ayant au moins un transducteur d'entrée et un transducteur de sortie sur l'un des côtés d'un corps piézoélectrique, en particulier monocristallin, comme partie active (1), qui est fixé par son autre côté sur le support métallique (2) à relier à la masse électrique, et sur un côté longitudinal (3) duquel sont prévues, dans un même plan, une languette de branchement (4) pour cette liaison à la masse et d'autres languettes (5 à 8) séparées du point de vue électrique et mécanique pour l'amenée du courant à la partie active (1) ou pour l'en évacuer par l'intermédiaire de fils de liaison (9 à 12), la partie active (1), en particulier le corps piézoélectrique, le support métallique (2) et les fils de liaison (9 à 12) étant logés dans un boîtier (14) dont l'ouverture (15) est obturée avec un élément de matière plastique (16) et avec un matériau adhésif et/ou de moulage, alors que les languettes de branchement (4 à 8) s'étendent vers l'extérieur, en passant par l'élément en matière plastique (16), caractérisé par le fait que le boîtier est un boîtier (14) en matière plastique qui est fait avec un matériau électriquement conducteur et déborde, par son ouverture (15), l'élément en matière plastique (16), et que le support métallique (2) se poursuit, à au moins une extrémité (19, 20) de son côté longitudinal (3) dirigé vers l'élément en matière plastique, par une languette supplémentaire de branchement (21, 22) qui, par sa partie dirigée vers l'extérieur, à partir de l'élément de matière plastique, est reliée galvaniquement à la partie débordante (18) du boîtier en matière plastique, au moyen d'un adhésif conducteur (23).

2. Composant électrique selon la revendication 1, caractérisé par le fait qu'au moins l'une des languettes de branchement à la masse (21, 22) est dimensionnée de telle façon que son point de séparation (24, 25), qui est produit lors de la fabrication, porte bord à bord, contre la paroi intérieure du boîtier en matière plastique (14) ou est situé au maximum à une distance de 1 mm de la paroi intérieure.

3. Composant électrique selon la revendication 1 ou 2, caractérisé par le fait qu'au moins l'une des languettes de branchement de la masse (21, 22) plonge, par ses extrémités libres (47), dans une fente (46) ménagée dans le bord (26) du boîtier en matière plastique, et, est reliée galvaniquement au boîtier en matière plastique à l'aide d'un adhésif conducteur.

4. Composant électrique selon l'une des revendications 1 à 3, caractérisé par le fait qu'au moins une languette de branchement à la masse (21, 22) est pourvue d'un prolongement qui sert en tant que languette supplémentaire (28) de branchement à la masse, pour la liaison à la masse.

5. Procédé pour la fabrication d'un composant électrique, d'un groupe de composants ou d'un circuit intégré, selon l'une des revendications 1 à 5, dans lequel le support métallique (2), ainsi que des languettes de branchement (4 à 8 et 28) sont d'abord découpés de telle façon dans une bande métallique d'un seul tenant (27), que la continuité de plusieurs supports métalliques (2) est assurée par une bande de base (29) avec laquelle les languettes de branchement (4 à 8 et 28) restent reliées, et par des pièces de liaison (30, 31) qui fournissent, avec la languette de liaison (4) pour la liaison à la masse, la liaison entre le support métallique (2) et les languettes de branchement (5 à 8 et 28), après quoi l'élément en matière plastique (16) est conformé autour des parties de branchement (32 à 36) des languettes de branchement (4 à 8) et autour de bandes métalliques (37, 38) du support métallique (2), en vue de former les pièces de liaison (30, 31), qu'avant ou après, la partie active (1) est fixée au support métallique (2) et est reliée électriquement, et de façon correspondante, à l'aide de fils (9 à 13) aux parties de branchement intérieures (32 à 36) que les pièces de liaison (30, 31) sont supprimées, le boîtier en matière plastique (14) est monté sur l'élément en matière plastique (16) et y est relié à l'aide d'un adhésif ou d'une matière coulable (16) et est fermé de façon étanche, et que finalement les languettes de branchement (4 à 8 et 28) sont séparées de la bande de base (29), suivant des longueurs correspondantes, le passage des bandes métalliques (37, 38) du support métallique (2) vers les pièces de liaison (30, 31) sont, lors du découpage et lors de la suppression des pièces de liaison (30, 31) conformées de telle façon que les languettes de branchement à la masse (21, 22) sont formées, languettes qui sont dirigées vers la paroi intérieure du boîtier en matière plastique (14) et portent bord à bord contre cette paroi, après la mise en place du boîtier en matière plastique (14), ou plongent dans des fentes ménagées dans le bord (26) du boîtier ou se situent au maximum à une distance de 1 mm de cette paroi, après quoi la liaison électrique (23) entre le boîtier en matière plastique (14) et les languettes de branchement à la masse (21, 22) a lieu par collage à l'aide d'un adhésif électriquement conducteur.

FIG 1

FIG 2

FIG 3

FIG 4

FIG 5